# EUROPEAN PATENT SPECIFICATION

(11) **EP 0 415 917 B1**
(45) Date of publication and mention of the grant of the patent: **09.03.1994**
(21) Application number: 88904500.1
(22) Date of filing: 27.04.1988
(51) Int. Cl.: B41J 5/10

(54) **KEYBOARD**
TASTATUR
CLAVIER

(43) Date of publication of application: 13.03.1991
(73) Proprietor: SORENSEN, Egon Nortoft, DK-5700 Svendborg (DK)
(72) Inventor: SORENSEN, Egon Nortoft, DK-5700 Svendborg (DK)
(74) Representative: Larsen, Hans Ole
(86) International application number: DK8800073
(87) International publication number: WO8910266

(56) References cited:
- CH-A- 499 829
- DE-A- 2 813 234
- US-A- 4 199 751
- US-A- 4 497 982

## Description

The invention relates to a keyboard for entering letters, numerals and other such symbols, the said keyboard comprising only seven keys, a central key and six other keys surrounding said central key, which other keys are positioned with two keys on one side, two keys on the other side of said central key, one key above and one key below said central key (see for example DE-A-2813234 or US-A-4497982).

Keyboards of this type are used where symbols are to be entered optionally by means of a keyboard. Typical examples are word processors, pushbotton telephones, calculators and the like.

The number of keys of these known keyboards is very large. For instance, an ordinary typewriter keyboard often comprises between 40 and 50 keys which take up a great deal of space and are time-consuming to operate. Moreover, the operation of these keyboards requires the use of both hands. Add to this that the position of the keys is not in accordance with the statistic frequency of using a particular key in relation to the position of the fingers.

These circumstances cause the operation of the keyboards to be time-consuming and may perhaps cause unnecessary strain on the body in that arms and fingers may be injured by the intensive strain caused by the keying operation.

It is the object of the invention to overcome these shortcomings and disadvantages of the known keyboards, and according to the invention this is achieved if said central key has a rounded shape, and the said other keys have an inner edge conforming to the shape of the adjacent part of said central key and are positioned close to each other, that the key spacing is such that one finger of a user is able to press up to any three of the seven keys including the said central key simultaneously, that the outer edge of the said six keys forms a rectangle, and that each key corresponds to a segment of a full symbol which segments together form the figure 8.

In a surprisingly simple manner this makes it possible to produce 127 different symbols by actuating from between one and seven keys at a time by using the seven keys and three fingers at the most.

This increases the keying speed considerably since the movement of the fingers is reduced to a minimum, and, in addition, the space requirement of a small and compact keyboard comprising seven keys is highly reduced.

If the central key is surrounded by the other six, the operation is further simplified since the fingers can actuate several keys simultaneously, and the keys are positioned close to each other, one finger can actuate more neighbouring keys simultaneously.

By designing the keyboard so that the signal is released by actuating those keys as do not form part of the required symbol, it will be easy to learn how to operate the keyboard since the entered symbol can be read by observing the non-actuated keys.

If a luminous line is inserted in each key which together will form the figure 8, a visual indication and hence simplification of the operation is obtained.

Finally, it is expedient to switch off the light in the actuated key or keys; the light in the non-actuated keys will then indicate the entered symbol.

In the following the invention will be described in more detail with reference to the drawing, where
Fig. 1 shows a top view of the keyboard,
fig. 2 shows the keyboard with luminous lines,
fig. 3 shows the keyboard when keying "a",
fig. 4 shows the keyboard when keying "b",
fig. 5 shows the keying of an alphabet from "a-ø", and
fig. 6 shows the keying of the numerals "0-9".

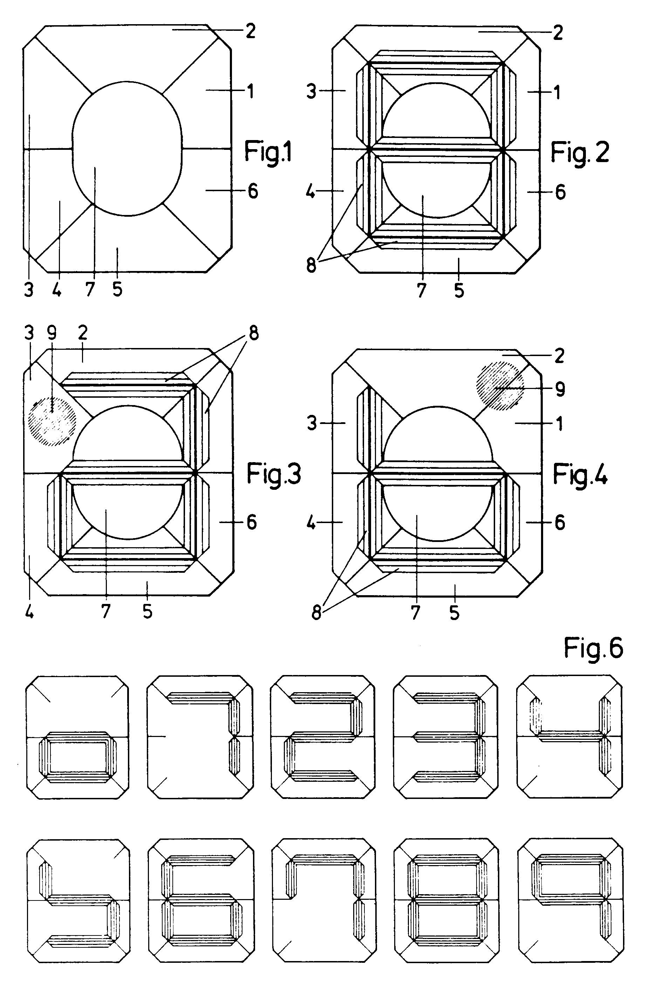

Figs. 1-4 show an example of a preferred embodiment of a keyboard according to the invention.

This comprises seven keys 1-7 of which one key 7, the centre key, is oval whereas the other six keys 1-6 are placed around the centre key as shown in figs. 1-4.

Four of the keys, 3, 4 and 1, 6, respectively, are placed in pairs at each side of the centre key 7, whereas a single key 2 and 5 is positioned above and below the centre key 7.

All keys 1-7 are positioned close together so as to make the operation as easy as possible since the distance between the seven keys is very short.
A luminous line 8 is inserted in each of the keys, as shown in figs. 2-4. When none of the keys are actuated, the lines 8 form the figure 8 as shown in fig. 2. If it is not possible to insert such a luminous line this can still be indicated in a generally known manner by being printed on the surface of the key.

If the keyboard is designed so that the entered symbol appears as a luminous symbol on the non-actuated keys, the entered symbol is easily and quickly controlled. For illustrative purposes, the keyboard can be connected to an electronic display whereby there is agreement between the keyed symbol and the symbol appearing on the display.

In such cases where the required symbol is a letter or a numeral, the operator will actuate that or those keys that do not form part of the appearance of the symbol. Thus, a dark spot 9 in fig. 3 indicates how an actuation of the one key 3 will trigger off the entering of the letter "a", which is indicated on the other keys as a luminous "a". Similarly, fig. 4 shows the keying of the letter "b" by actuation of the keys 2 and 1 by depressing these keys at the dark spot 9. "b" will then appear on the non-actuated keys 3-7.

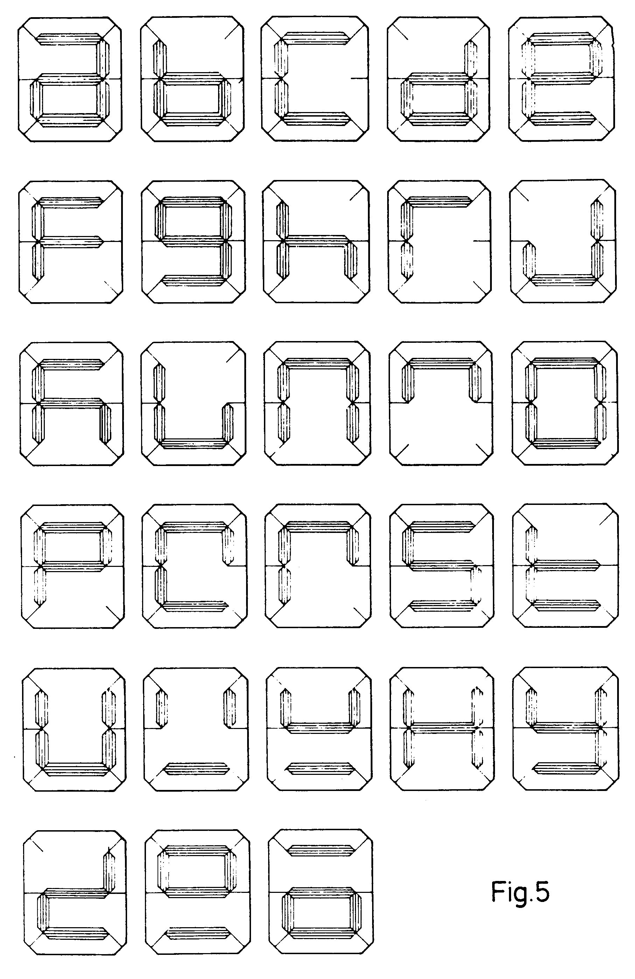

In certain cases the non-actuated keys do not look like quite like the familiar letters. Of an alphabet with the letters "a-ø" as shown in fig. 5, and the numerals "0-9" as shown in fig. 6, a total of 38 symbols, the 18 symbols can be produced by one finger, 17 symbols by two fingers simultaneously, and three symbols by three fingers simultaneously. A total of 127 different symbols can be produced by means of the seven keys of the keyboard.

If further symbols are required, for instance in order to provide a choice between small and capital letters or different printing types, a further separate key can be added or a special key combination for shifting the type can be provided, whereby at least twice the number of symbols can be produced.

The keyboard unit takes up only very litte space, and a maximum of three fingers is used for operating it. Consequently, working postures can be improved, and the keyboard can be used in connection with such devices where the use of a keyboard has so far been impossible due to the size of the known keyboards. Moreover, untrained users will find it easier to operate this simple keyboard, because the non-actuated keys provide an indication as to which symbol has been entered.

## Claims

1. Keyboard for entering letters, numerals and other such symbols, the said keyboard comprising only seven keys (1-7), a central key (7) and six other keys (1-6) surrounding said central key (7), which other keys (1-6) are positioned with two keys (3, 4) on one side, two keys (1, 6) on the other side of said central key (7), one key (2) above and one key (5) below said central key (7), **characterized** in that said central key (7) has a rounded shape, and the said other keys (1-6) have an inner edge conforming to the shape of the adjacent part of said central key (7) and are positioned close to each other, that the key (1-7) spacing is such that one finger of a user is able to press up to any three of the seven keys (1-7) including the said central key (7) simultaneously, that the outer edge of the said six keys (1-6) forms a rectangle, and that each key (1-7) corresponds to a segment of a full symbol which segments together form the figure 8.

2. Keyboard according to claim 1, **characterized** in that a line (8) is inserted into each key (1-7) to correspond to its segment of the symbol.

3. Keyboard according to claims 1-2, **characterized** in that the said line (8) is luminous.

4. Keyboard according to claims 1-3, **characterized** in that said luminous line (8) is switched off in a key (1-7) when it is pressed.

## Patentansprüche

1. Tastatur zur Eingabe von Buchstaben, Zahlen und anderen derartigen Symbolen mit nur sieben Tasten (1-7), von denen sechs Tasten (1-6) eine zentrale Taste (7) umgeben, wobei - jeweils bezogen auf die zentrale Taste (7) - zwei Tasten (3,4) an ihrer einen Seite, zwei Tasten (1,6) an ihrer anderen Seite, eine (2) oberhalb und eine Taste (5) unterhalb angeordnet sind, **dadurch gekennzeichnet**
daß die zentrale Taste (7) eine runde Form und die anderen, dicht nebeneinander angeordneten Tasten (1-6) einen inneren Rand aufweisen, der der Kontur des jeweils benachbarten Abschnitts der zentralen Taste (7) entspricht, daß der Tastenabstand so ist, daß ein Finger eines Benutzers gleichzeitig bis zu drei der sieben Tasten (1-7), einschließlich der zentralen Taste (7), drücken kann, daß der Außenrand aller Tasten (1-6) ein Viereck bildet, und daß jede Taste (1-7) einem Segment eines vollständigen Symbols entspricht, wobei alle diese Segmente zusammen die Figur einer 8 bilden.

2. Tastatur nach Anspruch 1, **dadurch gekennzeichnet,** daß in jede Taste (1-7) ein seinem Symbolsegment entsprechender Linienzug (8) eingebettet ist.

3. Tastatur nach Anspruch 1 oder 2, **dadurch gekennzeichnet,** daß der genannte Linienzug (8) leuchtend ist.

4. Tastatur nach den Ansprüchen 1 bis 3, **dadurch gekennzeichnet,** daß der genannte leuchtende Linienzug (8) in einer Taste (1-7) beim Drücken dieser Taste ausgeschaltet wird.

## Revendications

1. Clavier pour inscrire des lettres, des chiffres et autres symboles analogues, le clavier comportant seulement sept touches (1 - 7), une touche centrale (7) et six autres touches (1 - 6) entourant ladite touche centrale (7), lesquelles autres touches (1 - 6) sont positionnées avec deux touches (3, 4) d'un côté, deux touches (1, 6) de l'autre côté de ladite touche centrale (7), une touche (2) au-dessus et une touche (5) en-dessous de ladite touche centrale, caractérisé en ce que ladite touche centrale (7) a une forme arrondie et lesdites autres touches (1 - 6) ont un bord interne qui se conforme à la forme de la partie adjacente de ladite touche centrale (7) et sont positionnées au voisinage les unes des autres, en ce que l'espacement des touches (1 - 7) est tel qu'un seul doigt d'un utilisateur est susceptible d'enfoncer jusqu'à trois quelconques des sept touches (1 - 7) y compris ladite touche centrale (7) simultanément, en ce que le bord extérieur desdites six touches (1 -6) forme un rectangle et en ce que chaque touche (1 -7) correspond à un segment d'un symbole complet, lesquels segments pris ensemble constituent le chiffre huit.

2. Clavier selon la revendication 1, caractérisé en ce qu'une ligne (8) est insérée dans chaque touche (1 - 7) pour correspondre à son segment du symbole.

3. Clavier selon les revendications 1 - 2, caractérisé en ce que ladite ligne (8) est lumineuse.

4. Clavier selon les revendications 1 à 3, caractérisé en ce que la ligne lumineuse (8) est éteinte dans une touche (1 - 7) quand celle-ci est enfoncée.
